**Europäisches Patentamt**

**European Patent Office**

**Office européen des brevets**

(11) Numéro de publication : **0 520 375 B1**

(12) **FASCICULE DE BREVET EUROPEEN**

(45) Date de publication du fascicule du brevet :
**02.08.95 Bulletin 95/31**

(21) Numéro de dépôt : **92110566.4**

(22) Date de dépôt : **23.06.92**

(51) Int. Cl.⁶ : **H01L 39/14**

─────────────────────────

(54) **Pièce en céramique supraconductrice pour amener du courant.**

(30) Priorité : **27.06.91 FR 9107968**

(43) Date de publication de la demande :
**30.12.92 Bulletin 92/53**

(45) Mention de la délivrance du brevet :
**02.08.95 Bulletin 95/31**

(84) Etats contractants désignés :
**AT BE CH DE DK ES FR GB GR IT LI LU MC NL PT SE**

(56) Documents cités :
**EP-A- 0 292 387**
**EP-A- 0 311 331**
**PATENT ABSTRACTS OF JAPAN, vol. 14, no. 374 (E-964) 13 Août 1990 & JP-A-2 135 714**

(73) Titulaire : **GEC ALSTHOM SA**
**38, avenue Kléber**
**F-75116 Paris (FR)**

(72) Inventeur : **Bobo, Jean-Claude**
**2 Chemin de la Fosse Bidout**
**F-78120 Orphin (FR)**
Inventeur : **Herrmann, Peter**
**8, rue de la Ferme Thibault**
**F-91410 Corbreuse (FR)**
Inventeur : **Petitbon, Alain**
**23, rue des Menuets**
**F-78730 St Arnoult en Yvelines (FR)**
Inventeur : **Wicker, Alain**
**54, rue Vergniaud**
**F-75013 Paris (FR)**

(74) Mandataire : **Weinmiller, Jürgen et al**
**Lennéstrasse 9**
**Postfach 24**
**D-82336 Feldafing (DE)**

EP 0 520 375 B1

## Description

La présente invention concerne une pièce en céramique supraconductrice pour amenée de courant.

L'utilisation des supraconducteurs à très basse température (par exemple à 4,2 K, température de l'hélium liquide) demande que le courant soit conduit par des "amenées de courant" de la zone à température ambiante (≈ 300 K) à la zone à très basse température.

Le problème qui se pose est le transport de courants dont l'intensité soit supérieure à 1000 Ampères.

En général les amenées de courant sont réalisées à l'aide de conducteurs métalliques, éventuellement refroidis par les vapeurs du fluide cryogénique. Les besoins cryogéniques qui en résultent sont importants, et ne peuvent être réduits en-dessous d'une certaine limite, à cause du lien existant pour un métal entre les conductivités électrique et thermique (loi de Wiedemann Franz).

Après l'apparition des céramiques supraconductrices à haute température critique (ex. : 93 K pour $YBa_2Cu_3O_{6,9}$), il a été envisagé de réaliser des amenées de courant mixtes, comprenant un supraconducteur entre la très basse température (ex. : 4,2 K) et une température intermédiaire (ex. : 77 K, température de l'azote liquide), complété par un conducteur métallique entre la température intermédiaire et la température ambiante.

La céramique supraconductrice présente en effet l'avantage de ne pas produire de chaleur par effet Joule en régime continu, et d'en produire très peu sous certaines conditions en régime alternatif. $K(T)$ étant la conductivité thermique, les pertes théoriques par conduction thermique entre 4,2 K et 77 K définies par

$$\int_{4,2}^{77} K dT,$$

seraient de 58 KW/mètre pour le cuivre et 1,1 KW/mètre pour une céramique de type YBaCuO.

On connaît deux types d'amenées de courant basées sur ce principe qui ont été décrites dans les "Proceedings of Applied Superconductivity Conference". Snowmass - Colorado - 24 à 28 septembre 1990.

La première, mentionnée dans l'article de F. Grivon et al : "YBaCuO currents leads for liquid helium temperature applications", comprend un tube en céramique YBaCuO frittée, de diamètre intérieur 15 mm, de diamètre extérieur 20 mm et de longueur 120 mm capable de transporter un courant de 240 A. Il n'est pas possible d'atteindre la valeur souhaitée de 1000 A avec un tube de céramique frittée de ce type présentant une taille raisonnable.

La seconde amenée de courant connue, décrite dans l'article de J.L. Wu et al "Design and testing leads for liquid helium temperature applications", comporte un ensemble de vingt barreaux en céramique YBaCuO dont les dimensions sont 88 x 8,5 x 5,4 mm3. Une telle amenée de courant permet le transport de 1800 A, mais elle présente deux inconvénients : elle est encombrante et sa structure ne permet pas d'aboutir à une réduction suffisante des pertes thermiques vis-à-vis de celles d'un conducteur métallique classique.

La présente invention a pour but de proposer une pièce en céramique supraconductrice pour amenée de courant qui soit de réalisation relativement simple et qui soit capable de transporter entre un milieu à très basse température et un milieu à température intermédiaire, un courant de l'ordre de 1000 A avec des pertes thermiques très réduites vis-à-vis de celles d'un conducteur métallique habituel.

La présente invention a pour objet une pièce en céramique supraconductrice pour amenée de courant entre une zone à très basse température (par exemple 4,2 K) et une zone à température intermédiaire (par exemple 77 K), comprenant un tube en céramique frittée de la famille YBaCuO, caractérisée par le fait que ledit tube a une longueur supérieure à 50 mm, un diamètre extérieur compris entre 10 et 30 mm, une épaisseur comprise entre 1 et 4 mm, et qu'il présente dans au moins une partie de sa face latérale externe ou interne, entre ses deux extrémités, une zone où ladite céramique est texturée sur une profondeur comprise entre 30 μm et 500 μm.

Selon un mode de réalisation préférentiel, ladite zone texturée est constituée par au moins un canal dont la largeur est comprise entre 0,1 mm et 10 mm.

Selon une première variante, ledit canal est situé suivant une génératrice de ladite face latérale.

Selon une seconde variante, ledit canal a la forme d'une hélice coaxiale avec ledit tube.

Dans le cas le plus fréquent, plusieurs canaux seront prévus sur la face latérale externe de la pièce selon l'invention.

Les canaux peuvent être réalisés par tout moyen de chauffage localisé créant une fusion superficielle de la céramique frittée. Une telle fusion diminue le nombre de joints de grains de la céramique ou élimine certains types de défauts cristallins. Il est possible d'aboutir à des canaux présentant une densité de courant critique de l'ordre de 100 A/mm2 alors que la pièce en céramique frittée proprement dite a une densité de courant critique inférieure à 10 A/mm2.

On peut donc, en choisissant le nombre de canaux, avoir à sa disposition une pièce capable de transporter des courants supérieurs à 1000 A.

En outre la structure tubulaire de la pièce selon l'invention est particulièrement favorable à une limitation des pertes du point de vue thermique.

Selon un perfectionnement, le tube en céramique frittée d'une pièce selon l'invention peut lui-même être déposé sur un support tubulaire en un maté-

riau isolant, tel que $Al_2O_3$ ou MgO, ou en un métal choisi notamment parmi le cuivre, l'argent ou l'acier, ou en un matériau isolant recouvert d'une couche d'un tel métal. Le tube de céramique peut alors être déposé sur ledit support par une technique du type CVD, ablation laser, pulvérisation, etc... Ce mode de réalisation permet d'accroître la tenue mécanique de la pièce. La présence d'un support métallique ou d'une couche de métal constitue une protection pour le supraconducteur lorsque sa température critique est accidentellement dépassée et que le courant n'est pas coupé immédiatement.

D'autres caractéristiques et avantages de la présente invention apparaîtront au cours de la description suivante de modes de réalisation donnés à titre illustratif mais nullement limitatif. Dans le dessin annexé :

- La figure 1 est une vue schématique en coupe (ne respectant pas les échelles) d'une pièce supraconductrice selon l'invention.
- La figure 2 est une vue schématique en perspective d'une variante de pièce supraconductrice selon l'invention.

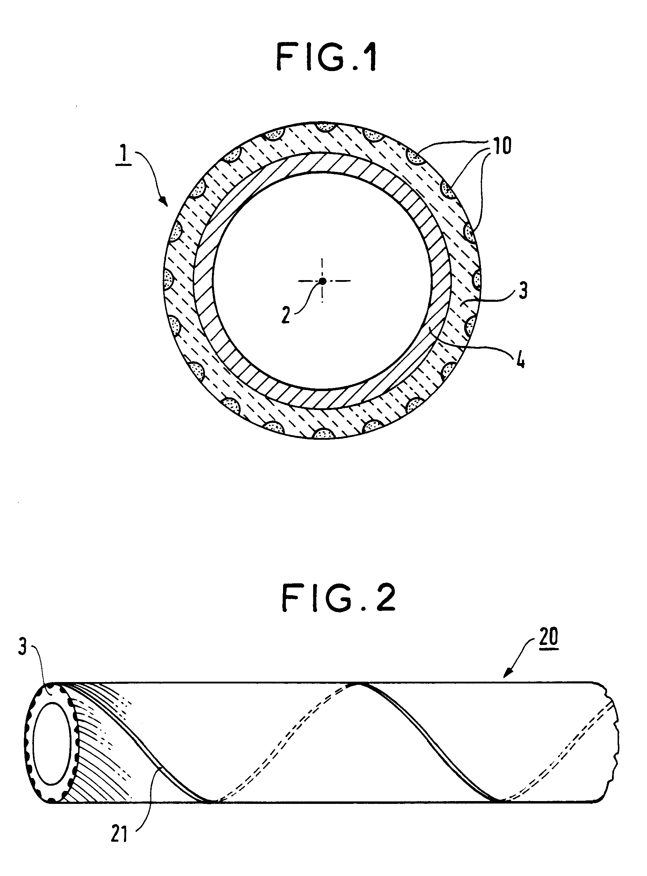

On voit dans la figure 1 une pièce tubulaire 1 d'axe 2 selon l'invention. Elle est constituée d'un support tubulaire métallique 4 en cuivre, de diamètre intérieur 14,8 mm, de diamètre extérieur 15 mm, et de longueur 100 mm.

Sur ce support a été déposé de façon connue un tube 3 en céramique YBaCuO frittée, de diamètre extérieur 18 mm. La pièce ainsi obtenue a une densité de courant critique inférieure à 10 A/mm2. On réalise une fusion localisée de la face externe du tube 3 au niveau de canaux 10 suivant des génératrices à l'aide d'un laser $CO_2$ pulsé. La fréquence des impulsions est de 700 Hz, avec une puissance de 3 KW/cm2, et une vitesse de balayage de 50 cm/minute ; la largeur du faisceau, définissant la largeur des canaux, est de 300 $\mu$m. La profondeur des canaux est de 300 $\mu$m.

On procède alors à un recuit à 900°C sous oxygène pendant 4 heures de façon à restaurer la phase supraconductrice orthorhombique. Chaque canal 10 peut alors supporter une densité de courant critique de 100 A/mm2. Avec 120 canaux 10 de ce type, on obtient une pièce capable de transporter un courant de 1080 A.

Les conditions d'utilisation du laser peuvent varier par exemple dans les limites suivantes :

- Fréquence des impulsions comprise entre 100 et 1000 Hz, et de préférence comprise entre 500 et 1000 Hz.
- Puissance comprise entre 1 et 5 KW/cm2, et de préférence comprise entre 2 et 4 KW/cm2.
- Vitesse de balayage comprise entre 10 et 100 cm/minute, et de préférence comprise entre 10 et 50 cm/minute.
- Largeur traitée comprise entre 0,1 mm et 10 mm.

Dans la figure 2, on voit une pièce 20 selon l'invention avec un tube 3 analogue à celui de la figure 1. Le canal 21 en céramique texturée, réalisé comme les canaux 10, a la forme d'une hélice de même axe que le tube 3.

Bien entendu l'invention n'est pas limitée aux modes de réalisation qui viennent d'être envisagés. Dans un cas limite, les divers canaux prévus sur la surface latérale du tube en céramique frittée peuvent être jointifs et recouvrir l'ensemble de cette surface.

L'opération de texturation peut être également menée à l'aide d'un anneau chauffant. Le chauffage par laser peut être remplacé par tout moyen analogue.

On a indiqué que la céramique appartenait à la famille des composés YBaCuO, mais on pourrait également utiliser tout composé de type $RBa_2Cu_3O_y$ où R désigne un lanthanide choisi parmi Y, La, Nd, Sm, Eu, Gd, Ho, Er, Tm, Yb, Lu et où y est compris entre 6,9 et 7.

## Revendications

1. Pièce en céramique supraconductrice pour amenée de courant entre une zone à très basse température et une zone à température intermédiaire, comprenant un tube en céramique frittée de la famille YBaCuO, caractérisée par le fait que ledit tube (3) a une longueur supérieure à 50 mm, un diamètre extérieur compris entre 10 et 30 mm, une épaisseur comprise entre 1 et 4 mm, et qu'il présente dans au moins une partie de sa face latérale externe ou interne, entre ses deux extrémités, une zone où ladite céramique est texturée sur une profondeur comprise entre 30 $\mu$m et 500 $\mu$m.

2. Pièce en céramique selon la revendication 1, caractérisée par le fait que ladite zone texturée est constituée par au moins un canal (10) dont la largeur est comprise entre 0,1 mm et 10 mm.

3. Pièce en céramique supraconductrice selon la revendication 2, caractérisée par le fait que ledit canal est situé suivant une génératrice de ladite face latérale.

4. Pièce en céramique supraconductrice selon la revendication 2, caractérisée par le fait que ledit canal (21) est situé suivant une hélice coaxiale avec ledit tube.

5. Pièce en céramique supraconductrice selon l'une des revendications précédentes dans laquelle ladite zone est située sur ladite face latérale externe dudit tube et caractérisée par le fait que ledit tube (3) est lui-même déposé sur un support tubulaire (4).

6.  Pièce en céramique supraconductrice selon la revendication 5, caractérisée par le fait que ledit support tubulaire est en un matériau isolant, tel que Al$_2$O$_3$, MgO.

7.  Pièce en céramique supraconductrice selon la revendication 5, caractérisée par le fait que ledit support tubulaire est constitué d'un tube en matériau isolant muni d'un revêtement métallique.

8.  Pièce en céramique supraconductrice selon la revendication 5, caractérisée par le fait que ledit support tubulaire est en un métal choisi parmi le cuivre, l'argent et l'acier.

## Patentansprüche

1.  Supraleitendes Keramikteil für die Stromzuführung zwischen einer Zone mit sehr niedriger Temperatur und einer Zone mit Zwischentemperatur, das ein Rohr aus gesinterter Keramik der Familie YBaCuO enthält, dadurch gekennzeichnet, daß das Rohr (3) eine Länge von mehr als 50 mm, einen Außendurchmesser zwischen 10 und 30 mm, eine Dicke zwischen 1 und 4 mm besitzt und daß es in mindestens einem Teilbereich seiner äußeren oder inneren Seitenfläche zwischen seinen beiden Enden eine Zone aufweist, in der die Keramik über eine Tiefe zwischen 30 μm und 500 μm texturiert ist.

2.  Keramikteil nach Anspruch 1, dadurch gekennzeichnet, daß die texturierte Zone aus mindestens einem Kanal (10) besteht, dessen Breite zwischen 0,1 mm und 10 mm liegt.

3.  Supraleitendes Keramikteil nach Anspruch 2, dadurch gekennzeichnet, daß der Kanal entlang einer Mantellinie der Seitenfläche verläuft.

4.  Supraleitendes Keramikteil nach Anspruch 2, dadurch gekennzeichnet, daß der Kanal (21) die Form einer mit dem Rohr koaxialen Schraubenlinie hat.

5.  Supraleitendes Keramikteil nach einem der vorhergehenden Ansprüche, bei dem die Zone sich auf der äußeren Seitenfläche des Rohrs befindet, dadurch gekennzeichnet, daß das Rohr (3) selbst auf einem rohrförmigen Träger (4) aufgebracht ist.

6.  Supraleitendes Keramikteil nach Anspruch 5, dadurch gekennzeichnet, daß der rohrförmige Träger aus einem isolierenden Material wie z.B.

Al$_2$O$_3$ oder MgO ist.

7.  Supraleitendes Keramikteil nach Anspruch 5, dadurch gekennzeichnet, daß der rohrförmige Träger von einem Rohr aus isolierendem Material mit einer metallischen Umhüllung gebildet wird.

8.  Supraleitendes Keramikteil nach Anspruch 5, dadurch gekennzeichnet, daß der rohrförmige Träger aus einem Metall besteht, das aus Kupfer, Silber und Stahl ausgewählt wird.

## Claims

1.  A superconductive ceramic part for a current lead between a region at very low temperature and a region at an intermediate temperature, the lead comprising a sintered ceramic tube of the YBaCuO family and being characterized by the fact that the length of said tube (3) is greater than 50 mm, its outside diameter lies in the range 10 mm to 30 mm, its thickness lies in the range 1 mm to 4 mm, and, in at least a portion of at least one of its inside and outside faces, it presents a textured region extending from one of its ends to the other, in which textured region said ceramic is textured to a depth lying in the range 30 μm to 500 μm.

2.  A superconductive ceramic part according to claim 1, characterized by the fact that said textured region is constituted by at least one channel (10) whose width lies in the range 0.1 mm to 10 mm.

3.  A superconductive ceramic part according to claim 2, characterized by the fact that said channel is situated along a generator line of said inside or outside face.

4.  A superconductive ceramic part according to claim 2, characterized by the fact that said channel (21) extends along a helix that is coaxial with said tube.

5.  A superconductive ceramic part according to any preceding claim, in which said textured region is situated on said outside face of said tube and characterized by the fact that said tube (3) is itself deposited on a. tubular support (4).

6.  A superconductive ceramic part according to claim 5, characterized by the fact that said tubular support is made of an insulating material such as Al$_2$O$_3$ or MgO.

7.  A superconductive ceramic part according to claim 5, characterized by the fact that said tubular support is constituted by a tube of insulating material provided with a metal coating.

8. A superconductive ceramic part according to claim 5, characterized by the fact that said tubular support is made of a metal selected from copper, silver, and steel.

# FIG.1

# FIG.2